# EUROPEAN PATENT APPLICATION

(11) **EP 4 718 962 A1**
(43) Date of publication of application: **01.04.2026**
(21) Application number: 25205630.4
(22) Date of filing: 30.09.2025
(51) Int. Cl.: H05K 7/20

(54) **COOLING UNIT HEAT RECOVERY**

(30) Priority: 30.09.2024 US 202463701530 P; 26.09.2025 US 202519342437
(71) Applicant: Vertiv International GmbH, 8212 Neuhausen am Rheinfall (CH)
(72) Inventor: MOSCHENI, Andrea, 8212 Schaffhausen (CH); MASETTO, Filippo, 8212 Schaffhausen (CH); GOBBO, Maurizio, 8212 Schaffhausen (CH)
(74) Representative: Kilburn & Strode LLP

(57) **Abstract**

An air cooling unit can include one or more heat exchangers in an air flow path, and one or more fans for moving air through the air cooling unit and through the one or more heat exchangers along the air flow path. The one or more heat exchangers can selectively recover heat from the air for use within a different part of a building housing the air cooling unit and/or for rejection outside of the building.

## Description

### CROSS-REFERENCE TO RELATED APPLICATION(S)

This application claims the benefit of U.S. Provisional Patent Application No. 63/701,530 filed September 30, 2024.

### TECHNICAL FIELD

The present disclosure relates generally to cooling units, such as those for use in data centers, and more specifically relates to recovering heat from such cooling units.

### BACKGROUND

Cooling units, such as those for use in data centers, typically extract heat generated by computer equipment and reject that heat to the environment, often through one or more cooling fluids, such as a water/glycol mixture and/or any of various refrigerants. Thus, the rejected heat is typically wasted.

There have been efforts to recover that heat, such as for use in building management systems. For example, recovered heat could be used to heat the rest of the building or for other purposes. However, such attempts to date have been overly complicated, ineffective, inefficient, or a combination thereof. For example, some current heat recovery systems require specialized equipment and/or occupy additional space in data centers, where space is at a premium.

### SUMMARY

Applicant has created new and useful devices, systems and methods for recovering heat from cooling units, such as those for use in data centers. Air cooling units are often used in data centers for transferring heat from computer equipment to an exterior environment using a chilled water/glycol mixture, a refrigerant, another cooling fluid, or any combination thereof. For example, heat from computer racks inside a room, such as a computer room of a data center or other building, can be extracted using an air cooling unit. That heat can be transferred to an environment outside of the building via the cooling fluid and rejected into the environment using a chiller and/or a condenser. In at least one example, a cooling system according to the disclosure can recover and utilize waste heat, such as from a computer room, to control the temperature of portions of a building outside of the computer room. In at least one example, existing air cooling units can be retrofitted to recover heat without occupying additional space in the computer room. In these manners and others, examples of the disclosure can advantageously improve cooling system efficiency, reduce the cost of heat recovery, save space and help maximize power usage effectiveness (PUE).

In at least one example, an air cooling unit according to the disclosure can include at least one heat exchanger disposed in an air flow path, at least one air mover, such as a fan, for moving air through the air cooling unit and through the at least one heat exchanger along the air flow path, or any combination thereof. In at least one example, the at least one heat exchanger can selectively extract heat from the air for use within a building that houses the air cooling unit, such as a different part of that building, and/or can selectively extract heat from the air for rejection outside the building. In at least one example, the at least one heat exchanger can selectively precool air flowing along the air flow path. In at least one example, the air cooling unit can have an additional heat recovery coil, can receive an input of a need for heating, such as from a building management system, and can selectively open a heat recovery valve when a temperature difference allows for heat transfer, such as a temperature difference between an inlet water temperature from a heat recovery system and a return or supply air temperature (i.e., depending on the unit configuration).

In at least one example, the at least one heat exchanger can be a single heat exchanger that can transfer the heat from the air to one or more cooling fluids circulating in one or more cooling fluid circuits. In at least one example, a first portion of the cooling fluid can be selectively circulated within the building, such as to distribute that heat within the building. In at least one example, a second portion of the cooling fluid can be selectively circulated at least partially outside the building, such as to reject that heat outside of the building. In at least one example, the second portion of the cooling fluid can exchange the heat with another cooling fluid that can be selectively circulated at least partially outside the building. In at least one example, the cooling fluid can be selectively circulated within the building and exchange at least a portion of the heat with another cooling fluid that can be selectively circulated at least partially outside the building.

In at least one example, the at least one heat exchanger can include a first heat exchanger that can transfer at least a first portion of the heat from the air to a first cooling fluid that can be selectively circulated in a first cooling fluid circuit within the building and/or a second heat exchanger that can transfer at least a second portion of the heat to a second cooling fluid that can be selectively circulated in a second cooling fluid circuit at least partially outside the building, with or without a third heat exchanger between the second heat exchanger and the air. In at least one example, the first heat exchanger can be in the air flow path before or after the second heat exchanger.

In at least one example, the air cooling unit can include at least one flow control device, such as one or more valves, pumps, compressors, or any combination thereof. In at least one example, the air cooling unit can include at least one controller for controlling the flow control device(s), such as based at least in part on a signal from a distinct building management system. In at least one example, the controller can monitor or otherwise cooperate with at least one sensor, such as a temperature sensor(s), a differential temperature sensor(s), a flow sensor(s) and/or one or more other sensors for environmental variables. In at least one example, the controller can control the flow control device(s) based at least in part on the signal from the building management system and information from the one or more sensors.

In at least one example, an air cooling unit, such as those for use in data centers, can include at least one air mover for moving air through the air cooling unit along an air flow path, a first heat exchanger in the air flow path for selectively extracting heat from the air for use within a different part of a building that houses the air cooling unit, a flow control device for controlling flow of a cooling fluid through the first heat exchanger, a second heat exchanger in the air flow path for selectively extracting heat from the air for rejection outside the building, a controller for controlling the flow control device based at least in part on a signal from a building management system, or any combination thereof. In at least one example, the first heat exchanger can be in the air flow path upstream or downstream of the second heat exchanger. In at least one example, the controller can monitor at least one sensor and/or can control the flow control device based at least in part on the signal from the building management system and information from the at least one sensor.

In at least one example, the air cooling unit can be disposed in a computer room of the building. In at least one example, the first heat exchanger can selectively transfer heat from the air moving through the air cooling unit to the cooling fluid. In at least one example, the cooling fluid can circulate within the building and transfer heat from the computer room to a different room of the building.

In at least one example, an air cooling unit can be disposed in a computer room of a building and/or can have a first heat exchanger for transferring heat from within the computer room to a first cooling fluid which can reject the heat outside of the building. In at least one example, a method of recovering heat from an air cooling unit can include disposing a second heat exchanger within the air cooling unit and/or plumbing one or more of the heat exchangers to a building management system that can control a temperature of a portion of the building distinct from the computer room. In at least one example, the method can include disposing the second heat exchanger within pre-existing open space above or below and/or upstream or downstream of the first heat exchanger.

In at least one example, the method can include configuring a controller of the air cooling unit for controlling flow of a second cooling fluid through the second heat exchanger based at least in part on a signal from the building management system. In at least one example, the method can include configuring a controller of the air cooling unit for controlling flow of a second cooling fluid through the second heat exchanger based at least in part on a signal from the building management system and at least one sensor, such as a pre-existing sensor used by the controller for controlling the rejection of the heat outside of the building.

### BRIEF DESCRIPTION OF THE DRAWINGS

FIG. 1 is a simplified diagram of one of many examples of a cooling system according to the disclosure.
FIG. 2 is a simplified diagram of another one of many examples of a cooling system according to the disclosure.
FIG. 3 is a simplified diagram of yet another one of many examples of a cooling system according to the disclosure.
FIG. 4 is a simplified diagram of still another one of many examples of a cooling system according to the disclosure.
FIG. 5 is a simplified diagram of another of many examples of a cooling system according to the disclosure.
FIG. 6 is a simplified diagram of yet another of many examples of a cooling system according to the disclosure.
FIG. 7 is a simplified diagram of one of many examples of a computer room according to the disclosure.
FIG. 8 is a flow chart of a method for recovering heat according to the disclosure.
FIG. 9 is a simplified diagram of a portion of one of many examples of an air cooling unit according to the disclosure.
FIG. 10 is a simplified diagram of a portion of another one of many examples of an air cooling unit according to the disclosure.

### DETAILED DESCRIPTION

The figures described above and the detailed description of specific structures and functions below are not presented to limit the scope of what Applicant has invented or the scope of the appended claims. Rather, the figures and written description are provided to teach any person skilled in the art to make and use the techniques for which patent protection is sought. It must be understood that the techniques disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various examples of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of flowchart illustration can be implemented by special purpose hardware-based systems that perform the specified functions or acts, or combinations of special purpose hardware and computer instructions.

Applicant has created new and useful devices, systems and methods for recovering heat from cooling units, such as those used in data centers. In at least one example, a cooling system according to the disclosure can utilize waste heat, such as from a computer room, to control the temperature of one or more portions of a building other than the computer room. In at least one example, existing air cooling units can be retrofitted to recover heat without occupying additional space in a computer room. In at least one example, waste heat recovery and utilization according to the disclosure can be implemented in or as part of one or more indoor air cooling units, such as, for example, a computer room air handler (CRAH), a computer room air conditioning (CRAC) unit, a fan wall, an in-row cooling unit, or any combination thereof. In at least one example, one or more heat recovery coils can recover heat from circulating air and precool the air, such as air circulated through or by IT equipment being cooled. In at least one example, a cooling system according to the disclosure can receive an input of a need for heating from a building management system, a dry contact, and/or one or more other sources, and can open a heat recovery valve when a temperature difference between an inlet water temperature and a return/supply air temperature (i.e., depending on the unit configuration) allows or provides for heat transfer.

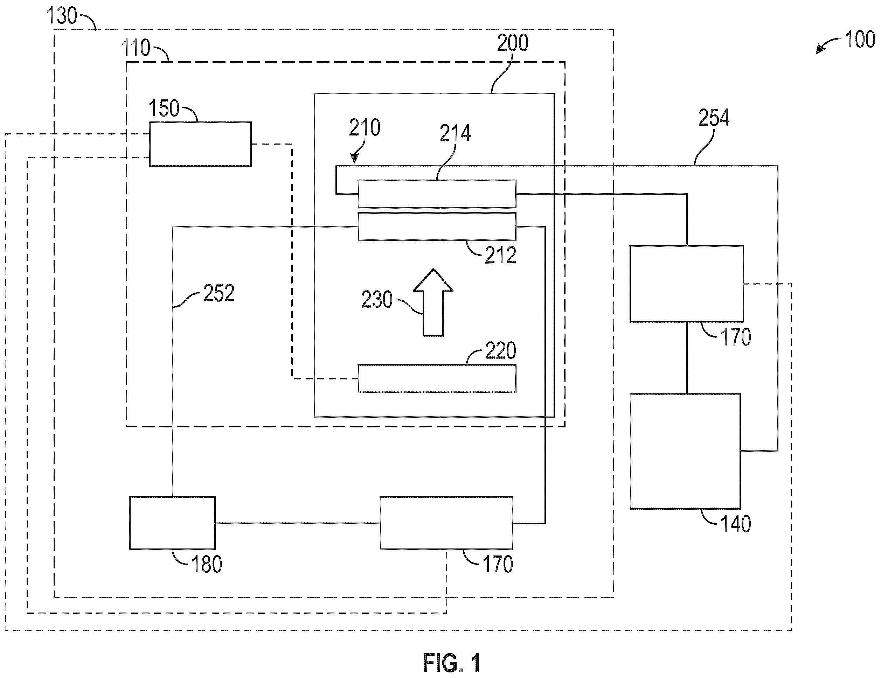

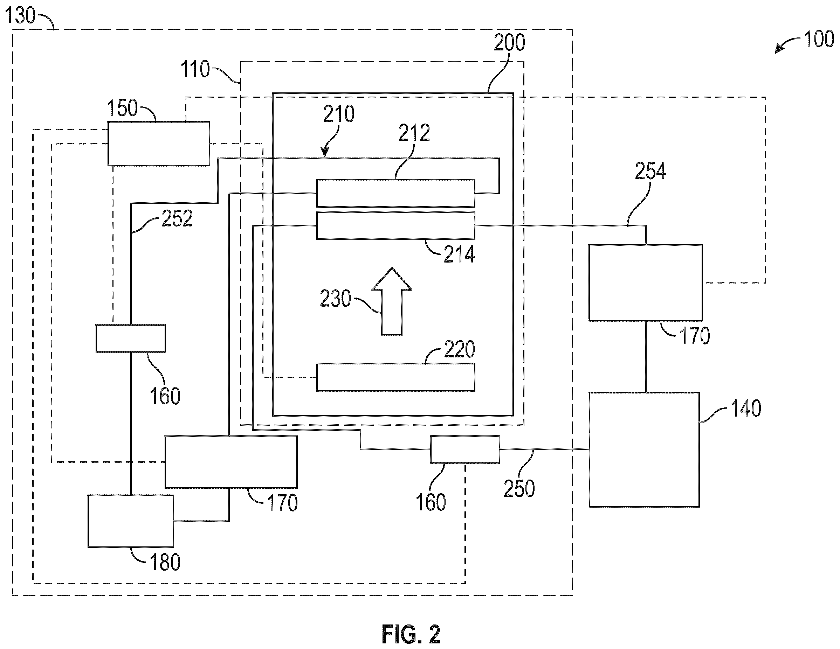

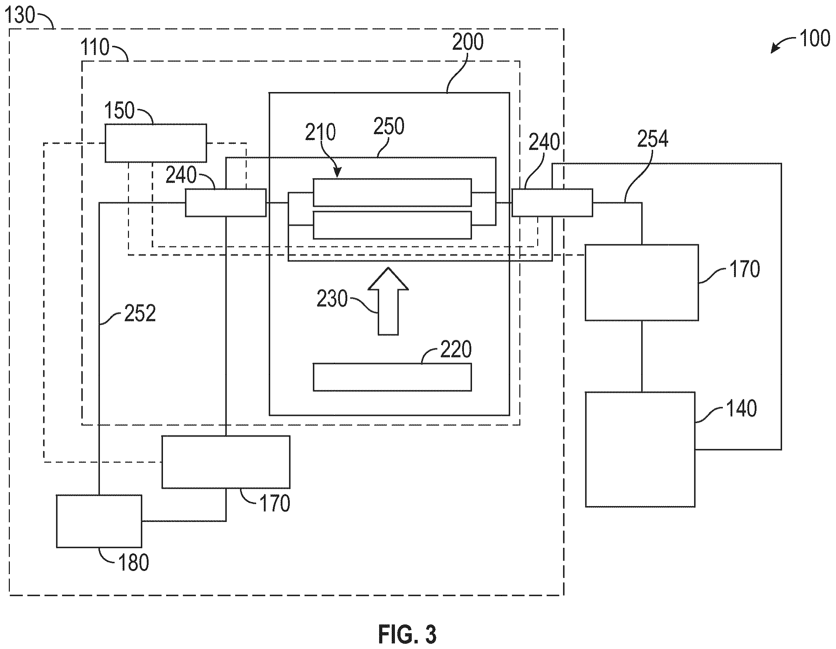

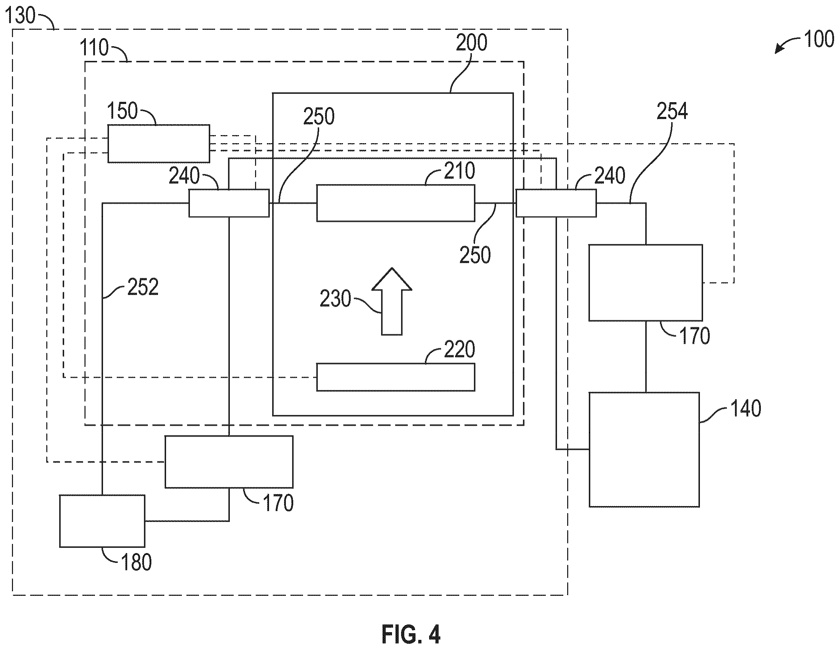

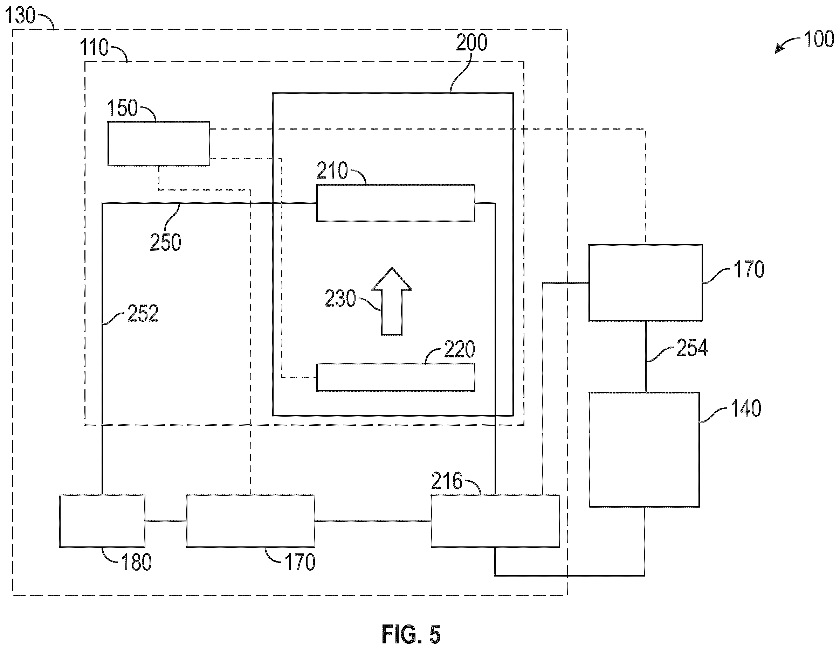

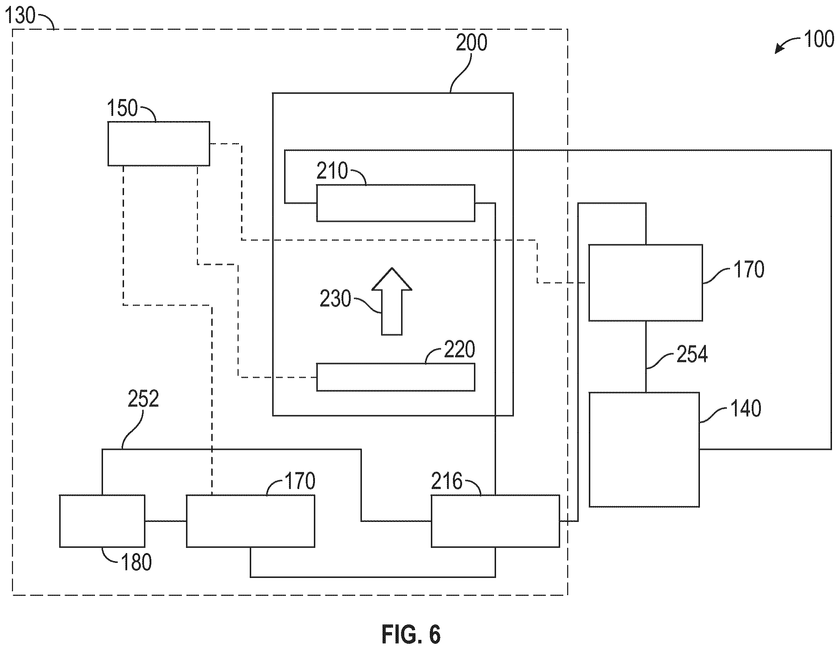

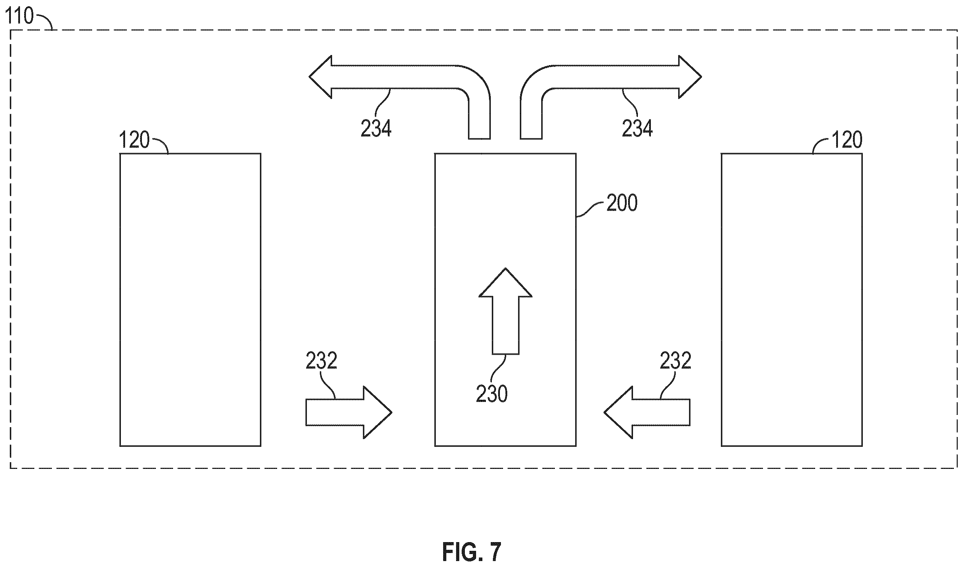

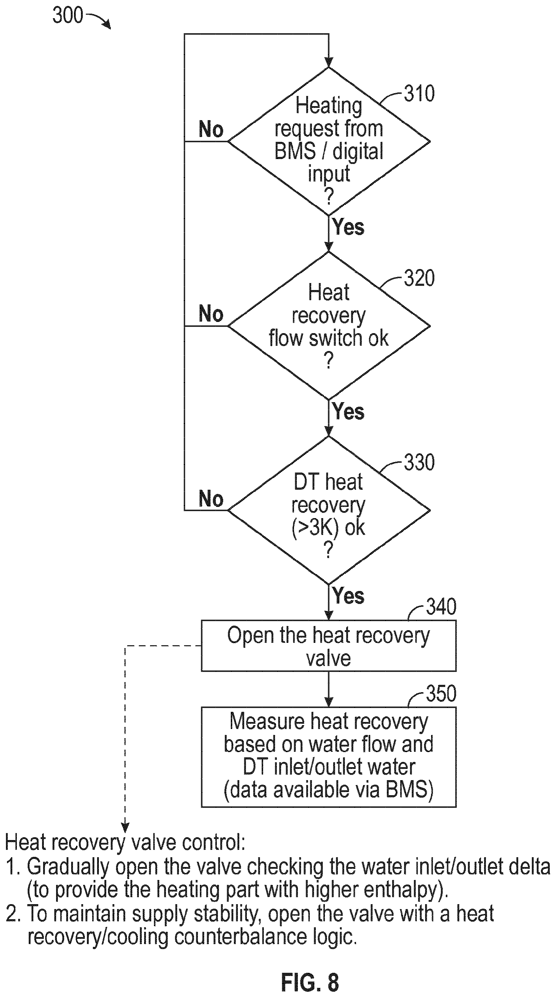

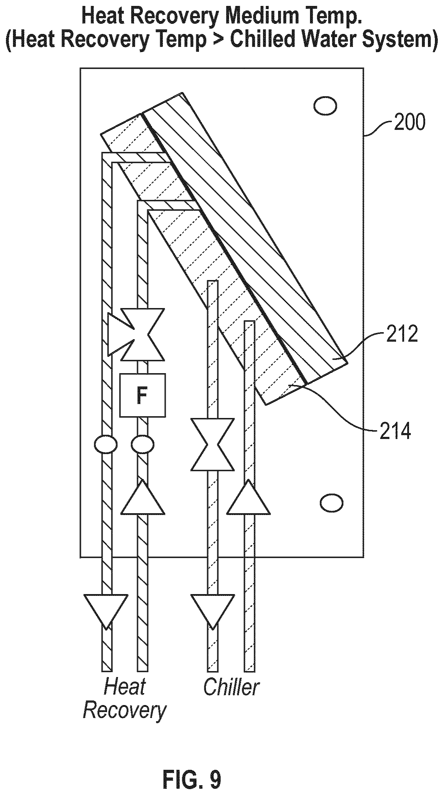

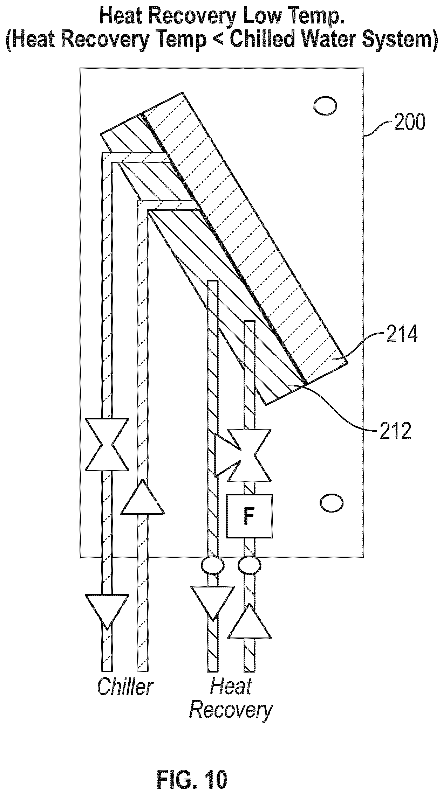

FIG. 1 is a simplified diagram of one of many examples of a cooling system according to the disclosure. FIG. 2 is a simplified diagram of another one of many examples of a cooling system according to the disclosure. FIG. 3 is a simplified diagram of yet another one of many examples of a cooling system according to the disclosure. FIG. 4 is a simplified diagram of still another one of many examples of a cooling system according to the disclosure. FIG. 5 is a simplified diagram of another of many examples of a cooling system according to the disclosure. FIG. 6 is a simplified diagram of yet another of many examples of a cooling system according to the disclosure. FIG. 7 is a simplified diagram of one of many examples of a computer room according to the disclosure. FIG. 8 is a flow chart of a method for recovering heat according to the disclosure. FIG. 9 is a simplified diagram of a portion of one of many examples of an air cooling unit according to the disclosure. FIG. 10 is a simplified diagram of a portion of another one of many examples of an air cooling unit according to the disclosure. FIGS. 1-10 are described in conjunction with one another.

In at least one example, a cooling system 100 according to the disclosure can include one or more air cooling units 200, such as for use in computer rooms 110. For example, one or more air cooling units 200 can be arranged for extracting heat from one or more computer racks 120 (e.g., servers or other information technology (IT) equipment) and rejecting that heat into an exterior environment outside of a building 130 via one or more cooling fluids and one or more chillers and/or condensers 140. In at least one example, the cooling fluid can circulate in one or more cooling fluid circuits and be or include a chilled water/glycol mixture, a refrigerant, another cooling fluid, or any combination thereof. In at least one example, the cooling system 100 and/or the air cooling unit 200 can include one or more controllers 150, one or more sensors 160, one or more flow control devices 170, or any combination thereof. In at least one example, the controller 150 can monitor the sensors 160 and/or control the flow of the cooling fluid through the cooling fluid circuits and the air cooling unit 200 using the flow control devices 170, such as based on information from the sensors 160. In at least one example, the sensors 160 can include one or more temperature sensors, one or more differential temperature sensors, one or more flow sensors, one or more pressure sensors, one or more differential pressure sensors, or any combination thereof. In at least one example, the flow control devices 170 can include one or more valves, one or more pressure regulators, one or more pumps, one or more compressors, or any combination thereof. In at least one example, heat from the computer racks 120 inside the computer room 110 of the building 130 can be extracted using the air cooling unit 200. In at least one example, that heat can be transferred to the environment outside of the building 130 via the cooling fluid and rejected into the environment using the chiller and/or condenser 140.

In at least one example, the air cooling unit 200 can recover the heat from the air in the computer room 110, such as by extracting that heat from cooling fluid circulating in a cooling fluid circuit 250 between the air cooling unit 200 and the computer racks 130, directly from the computer racks 130, or any combination thereof. In at least one example, the air cooling unit 200 can include one or more heat exchangers 210, which can include air-to-fluid heat exchangers and/or fluid-to-fluid heat exchangers. In at least one example, the air cooling unit 200 can include one or more air movers 220, such as one or more fans and/or one or more blowers, which can move air through the air cooling unit along an air flow path 230. In at least one example, the air flow path 230 can extend beyond the air cooling unit 200 and can include one or more hot air paths 232 to the air cooling unit 200 from the computer racks 120 and/or one or more cold air paths 234 from the air cooling unit 200 to the computer racks 120. In at least one example, the hot air path 232 and/or the cold air path 234 can enter and/or exit the air cooling unit 200 from the top, the bottom, the front, the back, the side, or any combination thereof.

In at least one example, an air cooling unit 200 can have one or more air flow paths 230 there through, one or more heat exchangers 210 in the air flow path 230, one or more air movers for moving air through the air cooling unit 200 and through the heat exchanger(s) 210 along the air flow path 230, or any combination thereof. In at least one example, the heat exchanger(s) 210 can selectively extract heat from the air for use within a different part of the building 130 housing the air cooling unit 200 and/or selectively extract heat from the air for rejection outside the building 130.

In at least one example, the heat exchanger(s) 210 can include one or more recovery heat exchangers 212 that can transfer at least a first portion of the heat from the air to a first cooling fluid that can be selectively circulated in a first cooling fluid circuit 252 within the building 130 and/or one or more rejection heat exchangers 214 that can transfer at least a second portion of the heat to a second cooling fluid that can be selectively circulated in a second cooling fluid circuit 254 at least partially outside the building 130, with or without one or more intermediate heat exchangers 216. In at least one example, the intermediate heat exchanger 216 can be thermally coupled between the rejection heat exchanger 214 and the air. In at least one example, the intermediate heat exchanger 216 can be thermally coupled between the rejection heat exchanger 214 and the environment outside the building 130.

In at least one example, the air cooling unit 200 can house the recovery heat exchanger 212, the rejection heat exchanger 214, the intermediate heat exchanger 216, or any combination thereof. In at least one example, the recovery heat exchanger 212, the rejection heat exchanger 214, the intermediate heat exchanger 216, or any combination thereof, can be disposed outside of the air cooling unit 200 partially or totally. In at least one example, the air cooling unit 200 can house the rejection heat exchanger 214, with or without the intermediate heat exchanger 216, and the rejection heat exchanger 214 can be disposed fluidically upstream of the recovery heat exchanger 212.

In at least one example, the air moving along the air flow path 230 can communicate with the recovery heat exchanger 212 before or after such air communicates with the rejection heat exchanger 214. In at least one example, the air moving along the air flow path 230 can communicate with the intermediate heat exchanger 216 rather than the rejection heat exchanger 214. In at least one example, the air moving along the air flow path 230 need not directly communicate with the recovery heat exchanger 212, the intermediate heat exchanger 216, the rejection heat exchanger 214, or any combination thereof.

In at least one example, the air cooling unit 200 can include at least one flow control device 170, such as one or more valves, pumps, compressors, or any combination thereof. In at least one example, the air cooling unit 200 can include at least one controller 150 for controlling the flow control device(s) 170, such as based at least in part on a signal from a building management system 180, which can be or include a building management system 180 distinct from the controller 150. In at least one example, the controller 150 can monitor the sensor(s) 160 and control the flow control device(s) 170 based at least in part on the signal from the building management system 180 and information from the sensor(s) 160.

In at least one example, the building management system 180 can control a temperature of a portion of the building 130 separate and distinct from the computer room 110. In at least one example, the building management system 180 can control the temperature of an office within the building 130 but outside of the computer room 110. In at least one example, the building management system 180 can control the temperature of an office partitioned off from the computer room 110. In at least one example, the system 100 can utilize waste heat generated by the computer racks 120 to control the temperature of the office, or another enclosed space separate and distinct from the computer room 110, or even from the building 130 itself.

In at least one example, the controller 150, the sensor(s) 160, the flow control device(s) 170, the building management system 180, the heat exchanger(s) 210, the rejection heat exchanger 214, the intermediate heat exchanger 216, or any combination thereof, can be pre-existing, and the recovery heat exchanger 212 can be operably coupled to the air cooling unit 200 (e.g., in a retrofit application). In at least one example, the controller 150, the sensor(s) 160, the flow control device(s) 170, the rejection heat exchanger 214, the intermediate heat exchanger 216, or any combination thereof, can be utilized to reject heat from the computer room 110 to outside of the building 130 independently of the building management system 180 controlling the temperature of the building 130 separate and distinct from the computer room 110, such as without the recovery heat exchanger 212 coupled to the air cooling unit 200. In at least one example, the recovery heat exchanger 212 can be coupled to the air cooling unit 200 and can permit the building management system 180 to utilize heat from the computer racks 120 in controlling the temperature of the building 130 or a portion thereof separate and distinct from the computer room 110.

In at least one example, the air cooling unit 200 can include one or more manifolds 240 to control flow of the cooling fluids through the heat exchangers 210, 212, 214. In at least one example, the manifolds 240 can include one or more valves or other flow control devices 170. In at least one example, the manifolds 240 can selectively permit either one of the heat exchangers 210 to operate as the recovery heat exchanger 212, rejection heat exchanger 214, intermediate heat exchanger 216, or any combination thereof. In at least one example, the controller 150 can control the manifolds 240 and/or flow control devices 170 to operate either one of the heat exchangers 210 as the recovery heat exchanger 212, rejection heat exchanger 214, intermediate heat exchanger 216, or any combination thereof.

In at least one example, the heat exchanger(s) 210 can be a single heat exchanger that can transfer the heat from the air to a cooling fluid circulating in a cooling fluid circuit 250. In at least one example, a first portion of the cooling fluid can be selectively circulated in a first cooling fluid circuit 252 within the building 130, such as to distribute that heat within the building 130. In at least one example, a second portion of the cooling fluid can be selectively circulated in a second cooling fluid circuit 254 at least partially outside the building 130, such as to reject that heat outside of the building 130. In at least one example, the second portion of the cooling fluid can exchange the heat with another cooling fluid that can be selectively circulated at least partially outside the building 130. In at least one example, the cooling fluid can be selectively circulated within the building 130 and exchange at least a portion of the heat with another cooling fluid that can be selectively circulated at least partially outside the building 130, such as through the intermediate heat exchanger 216, using one or more of the cooling fluid circuits 250.

In at least one example, an air cooling unit 200, such as those for use in data centers, can have one or more air flow paths 230 there through, at least one air mover 230 for moving air through the air cooling unit 200 along the air flow path 230, one or more recovery heat exchangers 212 in the air flow path 230 for selectively extracting heat from the air for use within a different part of a building 130 housing the air cooling unit 200, one or more flow control devices 170 for controlling flow of a cooling fluid through the recovery heat exchanger 212, one or more rejection heat exchangers 214 in the air flow path 230 for selectively extracting heat from the air for rejection outside the building 130, one or more controllers 150 for controlling the flow control device 170 based at least in part on one or more signals from one or more distinct building management systems 180, or any combination thereof.

In at least one example, the recovery heat exchanger 212 can be in the air flow path upstream or downstream of the rejection heat exchanger 214. In at least one example, the controller 150 can monitor one or more sensors 160 and/or control the flow control device(s) 170 based at least in part on the signal from the building management system 180 and information from the sensor 160. In at least one example, the controller 150 can monitor one or more sensors 160, such as temperature sensors, and can control one or more flow control device(s) 170, such as a heat recovery valve, when conditions support heat recovery operations. For example, in at least one example, the controller 150 can open one or more heat recovery valves when a temperature difference between an inlet water temperature and a return and/or supply air temperature allows heat transfer via the recovery heat exchanger 212. In at least one example, the system 100 can be arranged for medium temperature heat recovery, such as, for example, when a heat recovery temperature is greater than a water temperature along a chilled water loop. In at least one example, the system 100 can be arranged for low temperature heat recovery, such as, for example, when a heat recovery temperature is less than a water temperature along a chilled water loop. In at least one example, the system 100 can be arranged for providing a constant supply air temperature to the equipment being cooled and/or for improving the power usage effectiveness (PUE) by reducing the hot air temperature within the system (i.e., the relatively warm air leaving the equipment being cooled).

In at least one example, the air cooling unit 200 can be disposed in a computer room 110 of the building 130. In at least one example, the recovery heat exchanger 212 can selectively transfer heat from the air moving through the air cooling unit 200 to the cooling fluid circulating in one or more of the cooling fluid circuits 250. In at least one example, the cooling fluid can circulate within the building 130 and transfer heat from the computer room 110 to a different room of the building 130. In at least one example, the air cooling unit 200 can precool air moving through the air cooling unit 200.

In at least one example, a pre-existing air cooling unit 200, with the rejection heat exchanger 214, can be retrofitted with one or more recovery heat exchangers 212. In at least one example, an air cooling unit 200 can be disposed in a computer room 110 of a building 130 and/or can have one or more rejection heat exchangers 214 for transferring heat from within the computer room 110 to a first cooling fluid which can reject the heat outside of the building 130. In at least one example, a method of recovering heat from such an air cooling unit according to the disclosure can include disposing a recovery heat exchanger 212 within the air cooling unit 200 and/or plumbing one or more of the heat exchangers 210, 212, 214 to a building management system 180 that can control a temperature of a portion of the building 130 distinct from the computer room 110. In at least one example, the method can include disposing the recovery exchanger 212 within pre-existing open space above or below and/or upstream or downstream of the rejection heat exchanger 214.

In at least one example, the method can include configuring a controller 150 of the air cooling unit 200 for controlling flow of a second cooling fluid through the recovery heat exchanger 212 based at least in part on a signal from the building management system 180, such as a demand signal. In at least one example, the method can include configuring the controller 150 of the air cooling unit 200 for controlling flow of the second cooling fluid through the recovery heat exchanger 212 based at least in part on the signal from the building management system 180 and information from one or more sensors 160, such as a pre-existing sensor used by the controller 150 for controlling the rejection of the heat outside of the building 130. In at least one example, the information from the sensor(s) 160 can indicate whether or not heat (or excess heat) is available from the air cooling unit 200, such as by indicating whether there is a sufficient differential temperature across the air cooling unit 200 and/or there is sufficient flow through the air cooling unit 200 for supporting heat recovery operations.

In at least one example, a method 300 according to the disclosure can include determining whether there is a heating request from the building management system 180, as shown in step 310. Such a request can take the form of a dry contact closure (or opening), a digital signal, an analog signal, or any combination thereof. In at least one example, the method 300 can include determining whether there is adequate flow through the air cooling unit 200, as shown in step 320. In at least one example, the method 300 can include determining whether there is an adequate differential temperature across the air cooling unit 200, as shown in step 330. In at least one example, the method 300 can include activating a flow control device 170, such as a valve and/or a pump, to induce circulation of a cooling fluid between the air cooling unit 200 and the building management system 180, as shown in step 340. In at least one example, the method 300 can include monitoring the heat recovery, as shown in step 350.

In at least one example, a system according to the disclosure can include an air cooling unit (or air handler) for supporting the cooling of computer equipment and the rejection of heat to an exterior environment using one or more cooling media. For example, heat from computer racks inside a room of a data center or other building can be extracted and transferred to an environment outside of the building via a cooling fluid and rejected into the environment using a chiller and/or a condenser. In at least one example, an air cooling unit can have an air flow path, at least one heat exchanger in the air flow path, at least one air mover, such as a fan, for moving air through the air cooling unit and through the at least one heat exchanger along the air flow path, or any combination thereof. In at least one example, the at least one heat exchanger can selectively recover heat from the air for use within a building, such as a different part of the building, and/or for rejection outside of the building. In at least one example, the at least one heat exchanger can selectively recover heat from the air for pre-cooling the air flowing through the air cooling unit.

In at least one example, the at least one heat exchanger can be a single heat exchanger that can transfer the heat from the air to one or more cooling fluids circulating in one or more cooling fluid circuits. In at least one example, a first portion of the cooling fluid can be selectively circulated within the building, such as to distribute that heat within the building. In at least one example, a second portion of the cooling fluid can be selectively circulated at least partially outside the building, such as to reject that heat outside of the building. In at least one example, the second portion of the cooling fluid can exchange the heat with another cooling fluid that can be selectively circulated at least partially outside the building. In at least one example, the cooling fluid can be selectively circulated within the building and exchange at least a portion of the heat with another cooling fluid that can be selectively circulated at least partially outside the building.

In at least one example, the at least one heat exchanger can include a first heat exchanger that can transfer at least a first portion of the heat from the air to a first cooling fluid that can be selectively circulated in a first cooling fluid circuit within the building and/or a second heat exchanger that can transfer at least a second portion of the heat to a second cooling fluid that can be selectively circulated in a second cooling fluid circuit at least partially outside the building, with or without a third heat exchanger and/or fluid circuit between the second heat exchanger and the air. In at least one example, the air moving along the air flow path can communicate with the first heat exchanger before or after the second heat exchanger. In at least one example, the first heat exchanger can be disposed in the air flow path upstream of the second heat exchanger. In at least one example, the first heat exchanger can be disposed in the air flow path downstream of the second heat exchanger.

In at least one example, the air cooling unit can include at least one flow control device, such as one or more valves, pumps, compressors, or any combination thereof. In at least one example, the air cooling unit can include at least one controller for controlling the flow control device(s), such as based at least in part on a signal from a distinct building management system. In at least one example, the controller can monitor at least one sensor, such as temperature sensor(s), differential temperature sensor(s), flow sensor(s). In at least one example, the controller can control the flow control device(s) based at least in part on the signal from the building management system and information from the sensor(s).

In at least one example, an air cooling unit, such as those for use in data centers, can include at least one air mover for moving air through the air cooling unit along an air flow path, a first heat exchanger in the air flow path for selectively extracting heat from the air for use within a different part of a building housing the air cooling unit, a flow control device for controlling flow of a cooling fluid through the first heat exchanger, a second heat exchanger in the air flow path for selectively extracting heat from the air for rejection outside the building, a controller for controlling the flow control device based at least in part on a signal from a distinct building management system, or any combination thereof. In at least one example, the first heat exchanger can be in the air flow path upstream or downstream of the second heat exchanger. In at least one example, the controller can monitor at least one sensor and/or control the flow control device based at least in part on the signal from the building management system and information from the sensor.

In at least one example, the air cooling unit can be disposed in a computer room of the building. In at least one example, the first heat exchanger can selectively transfer heat from the air moving through the air cooling unit to the cooling fluid. In at least one example, the cooling fluid can circulate within the building and transfer heat from the computer room to a different room of the building.

In at least one example, an air cooling unit can be disposed in a computer room of a building and/or have a first heat exchanger for transferring heat from within the computer room to a first cooling fluid which can reject the heat outside of the building. In at least one example, a method of recovering heat from such an air cooling unit can include disposing a second heat exchanger within the air cooling unit and/or plumbing one or more of the heat exchangers to a building management system that can control a temperature of a portion of the building distinct from the computer room. In at least one example, the method can include disposing the second heat exchanger within pre-existing open space above or below and/or upstream or downstream of the first heat exchanger.

In at least one example, the method can include configuring a controller of the air cooling unit for controlling flow of a second cooling fluid through the second heat exchanger based at least in part on a signal from the building management system. In at least one example, the method can include configuring a controller of the air cooling unit for controlling flow of a second cooling fluid through the second heat exchanger based at least in part on a signal from the building management system and at least one sensor, such as a pre-existing sensor used by the controller for controlling the rejection of the heat outside of the building.

For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The present techniques have been described in the context of preferred and other examples and not every example of the present techniques has been described. Obvious modifications and alterations to the described examples are available to those of ordinary skill in the art having the benefits of the present disclosure. The disclosed and undisclosed examples are not intended to limit or restrict the scope or applicability of the present techniques conceived of by the Applicant, but rather, in conformity with the patent laws, Applicant intends to fully protect all such modifications and improvements that come within the scope or range of equivalents of the following claims.

Described herein are also the following clauses:
1. An air cooling unit having an air flow path, the air cooling unit comprising:
   at least one heat exchanger in the air flow path; and at least one air mover configured to move air through the air cooling unit and through the at least one heat exchanger along the air flow path, wherein the at least one heat exchanger is configured to selectively extract heat from the air for use within a building that houses the air cooling unit, and
   wherein the at least one heat exchanger is configured to selectively extract heat from the air for rejection outside of the building.
2. The air cooling unit of clause 1, wherein the at least one heat exchanger comprises a single heat exchanger that is configured to transfer the heat from the air to at least one cooling fluid circuit, wherein the at least one cooling fluid circuit is configured to selectively reject heat within the building, and wherein the at least one cooling fluid circuit is configured to selectively reject heat outside of the building.
3. The air cooling unit of any one of the clauses 1 to 2, wherein the at least one heat exchanger comprises a single heat exchanger that is configured to transfer the heat from the air to a first cooling fluid circuit, wherein the first cooling fluid circuit is configured to selectively circulate a first portion of a first cooling fluid within the building, and wherein the first cooling fluid circuit is configured to transfer heat from a second portion of the first cooling fluid to a second cooling fluid circuit that is configured to selectively circulate a second cooling fluid at least partially outside the building.
4. The air cooling unit of clause 1, wherein the at least one heat exchanger comprises a single heat exchanger that is configured to transfer the heat from the air to a first cooling fluid circuit, wherein the first cooling fluid circuit is configured to selectively circulate a first cooling fluid within the building, and wherein the first cooling fluid circuit is configured to exchange at least a portion of the heat with a second cooling fluid circuit that is configured to selectively circulate a second cooling fluid at least partially outside the building.
5. The air cooling unit of clause 1, wherein the at least one heat exchanger comprises a first heat exchanger that is configured to transfer at least a first portion of the heat from the air to a first cooling fluid circuit that is configured to selectively circulate a first cooling fluid within the building, and wherein the at least one heat exchanger comprises a second heat exchanger that is configured to transfer at least a second portion of the heat from the air to a second cooling fluid circuit that is configured to selectively circulate a second cooling fluid at least partially outside the building.
6. The air cooling unit of clause 5, wherein the first heat exchanger is disposed in the air flow path upstream of the second heat exchanger.
7. The air cooling unit of any one of the clauses 5 to 6, wherein the first heat exchanger is disposed in the air flow path downstream of the second heat exchanger.
8. The air cooling unit of any one of the preceding clauses, further including at least one flow control device and at least one controller configured to control the flow control device based at least in part on a signal from a building management system.
9. The air cooling unit of clause, wherein the controller is configured to monitor at least one sensor and control the flow control device based at least in part on the signal from the building management system and information from the sensor.
10. An air cooling unit having an air flow path, the air cooling unit comprising:
   at least one air mover configured to move air through the air cooling unit along the air flow path; a first heat exchanger in the air flow path and configured to selectively extract heat from the air for use within a building that houses the air cooling unit; a flow control device configured to control flow of a cooling fluid through the first heat exchanger;
   a second heat exchanger in the air flow path and configured to selectively extract heat from the air for rejection outside of the building; and a controller configured to control the flow control device based at least in part on a signal from a building management system.
11. The air cooling unit of clause 10, wherein the first heat exchanger is disposed in the air flow path upstream of the second heat exchanger.
12. The air cooling unit of any one of the clauses 10 to 11, wherein the first heat exchanger is disposed in the air flow path downstream of the second heat exchanger.
13. The air cooling unit of clause 10 to 12, wherein the controller is configured to monitor at least one sensor and control the flow control device based at least in part on the signal from the building management system and information from the sensor.
14. The air cooling unit of any one of the clauses 10 to 13, wherein the air cooling unit is configured to be disposed in a computer room of the building, wherein the first heat exchanger is configured to selectively transfer heat from the air moving through the air cooling unit to the cooling fluid, and wherein the cooling fluid is circulated within a cooling fluid circuit that is configured to transfer heat from the computer room to a different room of the building.
15. A method of recovering heat from an air cooling unit disposed in a computer room of a building, the air cooling unit having a first heat exchanger configured to transfer heat from within the computer room to a first cooling fluid which is configured to reject the heat outside of the building, the method comprising: disposing a second heat exchanger within the air cooling unit; and plumbing the second heat exchanger to a building management system that is configured to control a temperature of a portion of the building other than the computer room.
16. The method of clause 15, further comprising configuring a controller of the air cooling unit to control flow of a second cooling fluid through the second heat exchanger based at least in part on a signal from the building management system.
17. The method of any one of the clauses 15 to 16, further comprising configuring a controller of the air cooling unit to control flow of a second cooling fluid through the second heat exchanger based at least in part on a signal from the building management system and at least one sensor used by the controller to control the rejection of the heat outside of the building.
18. The method of any one of the clauses 15 to 17, wherein disposing the second heat exchanger within the air cooling unit comprises disposing the second heat exchanger within pre-existing open space above the first heat exchanger.
19. The method of clause 15, wherein disposing the second heat exchanger within the air cooling unit comprises disposing the second heat exchanger within pre-existing open space below the first heat exchanger.
20. The method of clause 15, wherein disposing the second heat exchanger within the air cooling unit comprises disposing the second heat exchanger within pre-existing open space in an airflow path through the air cooling unit upstream or downstream of the first heat exchanger.

## Claims

1. An air cooling unit having an air flow path, the air cooling unit comprising:
at least one heat exchanger in the air flow path; and
at least one air mover configured to move air through the air cooling unit and through the at least one heat exchanger along the air flow path,
wherein the at least one heat exchanger is configured to selectively extract heat from the air for use within a building that houses the air cooling unit, and
wherein the at least one heat exchanger is configured to selectively extract heat from the air for rejection outside of the building.

2. The air cooling unit of claim 1, wherein the at least one heat exchanger comprises a single heat exchanger that is configured to transfer the heat from the air to at least one cooling fluid circuit,
wherein the at least one cooling fluid circuit is configured to selectively reject heat within the building, and
wherein the at least one cooling fluid circuit is configured to selectively reject heat outside of the building.

3. The air cooling unit of claim 1, wherein the at least one heat exchanger comprises a single heat exchanger that is configured to transfer the heat from the air to a first cooling fluid circuit,
wherein the first cooling fluid circuit is configured to selectively circulate a first portion of a first cooling fluid within the building, and
wherein the first cooling fluid circuit is configured to transfer heat from a second portion of the first cooling fluid to a second cooling fluid circuit that is configured to selectively circulate a second cooling fluid at least partially outside the building.

4. The air cooling unit of claim 1, wherein the at least one heat exchanger comprises a single heat exchanger that is configured to transfer the heat from the air to a first cooling fluid circuit,
wherein the first cooling fluid circuit is configured to selectively circulate a first cooling fluid within the building, and
wherein the first cooling fluid circuit is configured to exchange at least a portion of the heat with a second cooling fluid circuit that is configured to selectively circulate a second cooling fluid at least partially outside the building.

5. The air cooling unit of claim 1, wherein the at least one heat exchanger comprises a first heat exchanger that is configured to transfer at least a first portion of the heat from the air to a first cooling fluid circuit that is configured to selectively circulate a first cooling fluid within the building, and
wherein the at least one heat exchanger comprises a second heat exchanger that is configured to transfer at least a second portion of the heat from the air to a second cooling fluid circuit that is configured to selectively circulate a second cooling fluid at least partially outside the building.

6. The air cooling unit of claim 5, wherein the first heat exchanger is disposed in the air flow path upstream of the second heat exchanger.

7. The air cooling unit of any one of the claims 5 to 6, wherein the first heat exchanger is disposed in the air flow path downstream of the second heat exchanger.

8. The air cooling unit of any one of the preceding claims, further including at least one flow control device and at least one controller configured to control the flow control device based at least in part on a signal from a building management system.

9. The air cooling unit as set forth in claim 8, wherein the controller is configured to monitor at least one sensor and control the flow control device based at least in part on the signal from the building management system and information from the sensor.

10. The air cooling unit of any one of the preceding claims, wherein the air cooling unit is configured to be disposed in a computer room of the building,
wherein the first heat exchanger is configured to selectively transfer heat from the air moving through the air cooling unit to the cooling fluid, and
wherein a cooling fluid is circulated within a cooling fluid circuit that is configured to transfer heat from the computer room to a different room of the building.

11. A method of recovering heat from an air cooling unit disposed in a computer room of a building, the air cooling unit having a first heat exchanger configured to transfer heat from within the computer room to a first cooling fluid which is configured to reject the heat outside of the building, the method comprising:
disposing a second heat exchanger within the air cooling unit; and
plumbing the second heat exchanger to a building management system that is configured to control a temperature of a portion of the building other than the computer room.

12. The method of claim 11, further comprising configuring a controller of the air cooling unit to control flow of a second cooling fluid through the second heat exchanger based at least in part on a signal from the building management system.

13. The method of any one of the claims 11 to 12, further comprising configuring a controller of the air cooling unit to control flow of a second cooling fluid through the second heat exchanger based at least in part on a signal from the building management system and at least one sensor used by the controller to control the rejection of the heat outside of the building.

14. The method of any one of the claims 11 to 13, wherein disposing the second heat exchanger within the air cooling unit comprises disposing the second heat exchanger within pre-existing open space above the first heat exchanger.

15. The method of claim 11, wherein disposing the second heat exchanger within the air cooling unit comprises disposing the second heat exchanger within pre-existing open space below the first heat exchanger; or
wherein disposing the second heat exchanger within the air cooling unit comprises disposing the second heat exchanger within pre-existing open space in an airflow path through the air cooling unit upstream or downstream of the first heat exchanger.
